# EUROPEAN PATENT APPLICATION

(11) **EP 0 964 446 A2**
(43) Date of publication of application: **15.12.1999**
(21) Application number: 99304251.4
(22) Date of filing: 01.06.1999
(51) Int. Cl.: H01L 21/60

(54) **An electronic circuit assembly**

(30) Priority: 04.06.1998 US 90350
(71) Applicant: Ford Motor Company, Dearborn, MI 48126 (US)
(72) Inventor: Yerdon, Timothy Joseph, 5304, Belleville, Michigan 48111 (US); Topping, Mark Stephen, Michigan 48146 (US); Paruchuri, Mohan R., Michigan 48187 (US)
(74) Representative: Messulam, Alec Moses

(57) **Abstract**

An electronic circuit assembly comprising a dielectric substrate having an electronic component thereon; a first copper bonding surface on the substrate or component; a second metallic bonding surface on the substrate or component; a layer of silver atop the copper bonding surface; and a wirebonding wire attached to the layer of silver and to the second metallic bonding surface.

## Description

The present invention relates generally to a method for producing an electronic circuit assembly, such as a printed circuit board (PCB), and more particularly to a method for wirebonding an electronic component in an electronic circuit assembly.

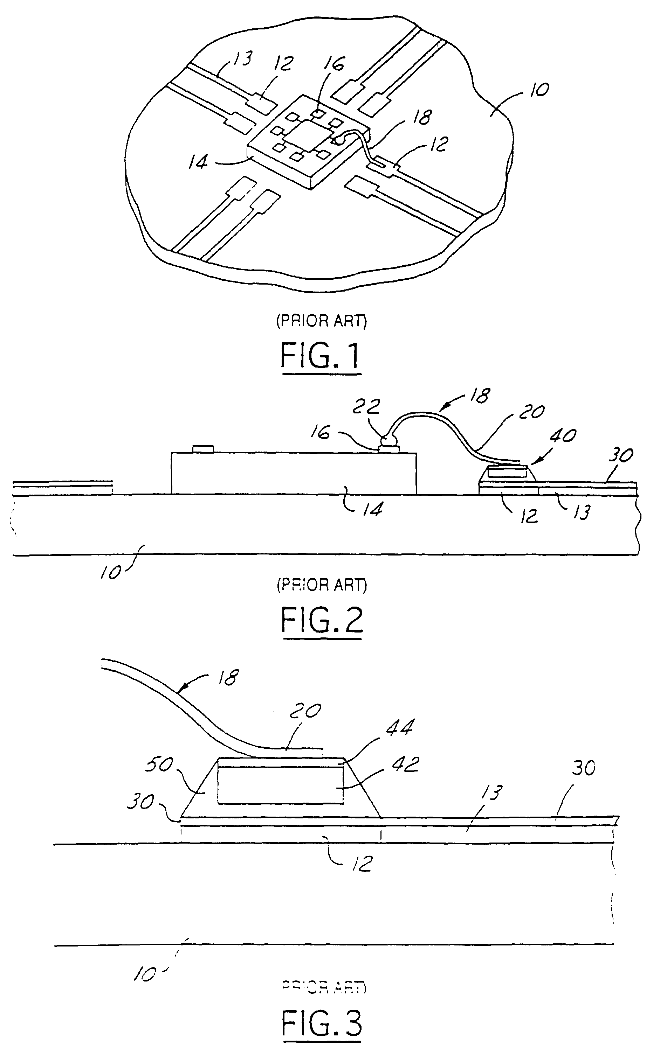

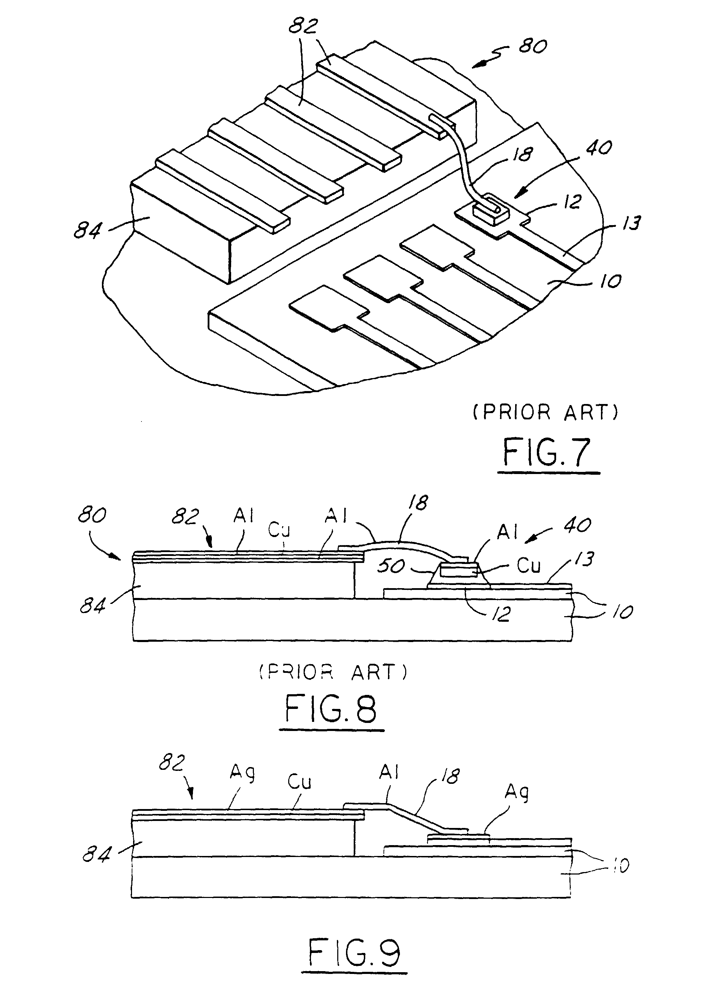

It is well known in the field of electronics manufacturing to attach an electronic component 14 having I/O bond pads 16 to a PCB substrate 10 and to connect the bond pads atop the component to corresponding substrate mounting pads 12 by a process known as "heavy" wirebonding. This is done, for example, in connecting bare die power transistors to FR-4 substrates, as illustrated in FIGS. 1-3, and in connecting connector leads/leadframe terminations 80 to substrates, as shown in FIGS. 7-8 . In typical heavy wirebonding applications, the mounting pads 12 and circuit traces 13 are made of copper, the bond pads 16 and outer leadframe surfaces out of aluminum or alloys thereof, and the wire 18 out of 10- to 20-mil-thick aluminum.

A related process is known as "fine" wirebonding, typically used to connect semiconductor die I/O bond pads to their corresponding leadframes as part of the manufacture of plastic- and ceramic-packaged integrated circuit chips. Fine wirebonding typically uses <10-mil-thick gold wire to connect the aluminum I/O bond pads to the leadframes.

Because copper oxide on the surface of a part interferes with wirebonding and soldering to that surface, and because copper oxidizes so aggressively when exposed to the atmosphere, the copper mounting pads 12 are typically covered with an antioxidant barrier or coating very soon after formation of the pads 12 on the substrate 10. Typical antioxidants or barriers used for this purpose include organic solder preservatives (OSPs), such as benzimidazole, imidazole, and benzotriozole, or, more commonly, tin/lead solder. Tin/lead solder coatings are usually applied to all exposed copper surfaces of a PCB by a process known as hot air solder leveling, or HASL. (In addition to copper mounting pads, oxidation is also a problem for connector leads and leadframe terminations 80, so these elements are typically constructed out of aluminum-copper or aluminum-copper-aluminum clad laminates, rather than out of only copper.)

After coating the mounting pads 12 and other exposed copper surfaces with solder or OSP, the PCB is then ready to be populated with components 14, then reflow or wave soldered, and then heavy wirebonded. The solder or OSP coatings atop the mounting pads 12 are relatively thin; however, these coatings often interfere with the wirebonding of the bonding wires 18 to the pads 12. Additionally, the metallurgical incompatibility of the aluminum (or gold) bonding wire 18 with the copper pads 12 also presents a problem; that is, undesirable intermetallic compounds are formed when such aluminum-to-copper (or gold-to-copper) bonding is attempted.

To address this problem, it is common practice to place and solder a wirebond pad 40 atop each mounting pad 12 and to then bond the wirebond wire 18 to this pad 40, as illustrated in FIGS. 2-3. The wirebond pad 40 has a copper base portion 42 and an aluminum top portion 44, and is typically placed on the copper mounting pad 12 using automated pick-and-place equipment, such as is used to place electronic components on the PCB. With the typical aluminum/copper sandwich construction of the pad 40 as illustrated, the copper base 42 is easily soldered to the copper mounting pad 12, and the aluminum wire 18 is likewise easily wirebonded to the aluminum top 42, without the aforementioned undesirable intermetallics being formed in either case. This process of using an intermediary wirebond pad 40 between the bond wire 18 and the mounting pads 12 works well and is used extensively throughout the electronics manufacturing industry.

However, this approach suffers from several drawbacks. First, the use of aluminum/copper wirebond pads 40 adds considerable piece part cost to the overall PCB assembly. Second, use of the pads 40 requires the aforementioned pick-and-place operation, thus increasing processing time, operational costs, and the opportunity for processing/placement errors. And third, HASL coatings are typically non-uniform in thickness, thus presenting a problem with non-planarity which is particularly a concern with fine-pitch components 14.

It would therefore be desirable to provide a method for wirebonding component bond pads 16 or connector leads/leadframe terminations to their corresponding mounting pads 12 without the aforementioned drawbacks. Additionally, it would further be desirable to provide such a process which might also obviate the use of the commonly used but lead-intensive, environmentally unfriendly, non-uniform thickness HASL processing.

The present invention overcomes the disadvantages of the prior art approaches by providing a method for producing an electronic circuit assembly, such as a printed circuit board (PCB), which obviates the need for conventional wirebond pads. The method comprises the steps of: (a) providing a dielectric substrate, an electronic component or an electrical connector leadframe, and a wirebonding wire having first and second ends, wherein a first copper bonding surface and a second metallic bonding surface are provided on the substrate, component, or leadframe; (b) depositing a first layer of silver atop the first copper bonding surface, thereby producing a first silvered bonding surface; (c) attaching the component or leadframe to the substrate such that the second metallic bonding surface is registered generally adjacent the first silvered bonding surface; and (d) wirebonding the first end of the wire to the first silvered bonding surface, and the second end of the wire to the second metallic bonding surface.

It is an object and advantage that the present invention provides a construction and method which eliminates the need for interposing wirebond pads between wirebond wires and their respective mounting pads.

Another advantage is that the method of the present invention is quicker, easier, less expensive, and more robust than conventional methods. Yet another advantage is that the present invention eliminates the need for HASL processing.

The invention will now be described, by way of example, with reference to the accompanying drawings, in which:
FIGS. 1-3 are perspective, side, and close-up side views, respectively, of an electronic component wirebonded to substrate mounting pads according to the prior art;
FIGS. 4-5 are side views of an electronic component wirebonded to substrate mounting pads according to the present invention;
FIG. 6 is a perspective view of an electronic circuit assembly according to the present invention;
FIGS. 7-8 are perspective and side views, respectively, of a leadframe wirebonded to a substrate mounting pad according to the prior art; and
FIG. 9 is a side view of a leadframe wirebonded to a substrate mounting pad according to the present invention.

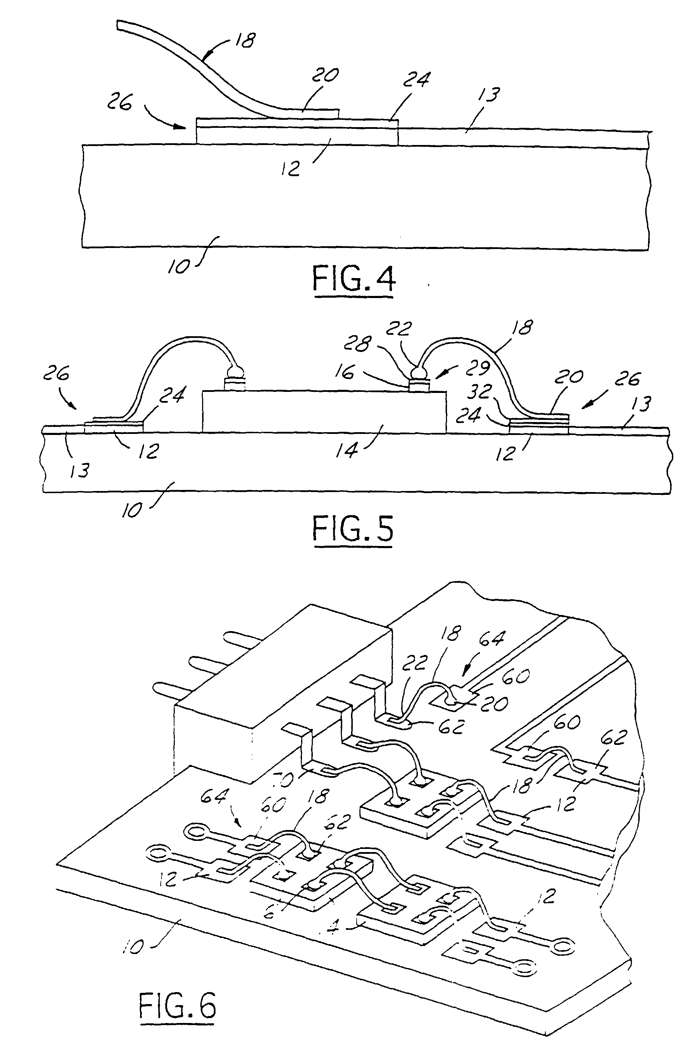

Referring now to the drawings, FIGS. 4-6 and 9 show an electronic circuit assembly according to the present invention. The assembly comprises: (a) a dielectric substrate 10 having an electronic component 14 or an electrical connector leadframe 80 attached thereon; (b) a first copper bonding surface 60 on the substrate 10, component 14, or leadframe 80; (c) a second metallic bonding surface 62 on the substrate 10, component 14, or leadframe 80, wherein the second metallic bonding surface 62 is disposed proximate the first copper bonding surface 60; (d) a first layer of silver 24 attached atop the first copper bonding surface 60; and (e) a wirebonding wire 18 having a first end 20 and a second end 22, wherein the first end 20 is attached to the layer of silver 24 atop the first copper bonding surface 60, and wherein the second end 22 is attached to the second metallic bonding surface 62.

To assist the reader in understanding the present invention, all reference numbers used herein are summarized in the table below, along with the elements they represent:
10 = Substrate
12 = Copper mounting pads atop substrate
13 = Copper circuit traces atop substrate
14 = Electronic component
16 = Bond pads atop electronic component
18 = Wirebonding wire
20 = First end of wirebonding wire
22 = Second end of wirebonding wire
24 = First layer of silver 26 = First silvered-bonding surface
28 = Second layer of silver
29 = Second silvered bonding surface
30 = Protective coating (e.g., OSP, HASL) 32 = Antioxidant coating (e.g., OSP, but not HASL)
40 = Copper/aluminum wirebond pad
42 = Copper base portion of wirebond pad
44 = Aluminum top portion of wirebond pad
50 = Solder joint (e.g., eutectic Sn/Pb)
60 = First copper bonding surface
62 = Second metallic bonding surface
64 = Layer of silver atop at least the first copper bonding surface
70 = Mounting sites on leadframes/terminal lugs/ other electrical connectors
80 = Electrical connector leadframe
82 = Individual lead element of the leadframe

The dielectric substrate 10 may be a conventional flat, rigid board of glass/epoxy FR-4, ceramic, or other materials, or it may be a flexible film of polyester, polyimide, polyetherimide, or the like. The electrical component 14 is attached to the substrate 10 (e.g., by soldering) and may be any passive or active surface mount component (SMC) or plated through-hole (PTH) component, such as packaged IC chips, bare semiconductor dice, leadless chip components (LCCs) (e.g., leadless resistors and capacitors), leaded resistors, capacitors, and transistors, and the like. The electrical connector leadframe 80 may be a metallic leadframe that is attached to or molded into the substrate 10 and which has multiple lead elements. Such connectors 80 are typically used to connect circuit traces 13 or electronic components 14 on the substrate 10 to electrical/electronic elements external to the substrate 10, thus serving as a bus or interconnect site between elements on and off the substrate.

The first copper bonding surface 60 is located on the substrate 10, the component 14, or the leadframe 80. When located on the substrate, the surface 60 is typically a copper mounting pad 12 or an exposed portion of a circuit trace 13. When located on a component 14, the bonding surface 60 is typically an I/O bond pad 16 or a termination/lead; when located on a leadframe 80, the bonding surface 60 is typically one of the individual lead elements 82. In most applications, the first copper bonding site 60 will be a copper substrate mounting pad 12 or a copper leadframe element 82.

The second metallic bonding surface 62 may be copper, but in most cases will be aluminum or some other metal to which the wirebond wire 18 may be bonded. Like the first bonding surface 60, the second surface 62 may be located on the substrate (e.g., a mounting pad 12), on the component (e.g., a lead/termination/bond pad), or on the leadframe 80 (e.g., a lead element 82). The second surface 62 should be disposed proximate the first surface 60, so that the wirebond wire 18 connecting the first and second surfaces 60/62 will not be inordinately long. For most applications, the desired proximity is within 1 inch, and preferably within 0.5 inch.

The first layer of silver 24 atop the first copper surface 60 is generally between 2 and 10 microinches thick, and may be deposited thereon by plating the surface 60 in an ionic silver solution (e.g., AgNO₃) using such processes as immersion plating, electroless plating, and/or electrolytic plating. It has been determined that a 2- to 10-microinch layer of silver is optimum as far as providing a sufficient coating of silver onto which to bond the wire 18 with sufficient reliability while at the same time minimizing the amount of silver needed. The preferred thickness is about 3 to 5 microinches.

The thin silver layer 24 atop each copper bonding surface 60 provides a cost-effective, more environmentally friendly alternative to traditional OSP and HASL coatings. It is particularly noteworthy that the present invention completely eliminates the need for wirebond pads 40 and the concomitant pick-and-place and soldering processes associated therewith, thus greatly reducing the overall cost of wirebonded PCBs which use the present invention.

If desired, an organic antioxidant, such as benzimidazole, imidazole, or benzotriozole, may be mixed in with the ionic silver solution, especially when immersion plating. Tests have shown that such ionic silver/antioxidant mixtures typically produce a layer of antioxidant 32 on the outer surface of the silver layer after immersion plating. Alternatively, as a separate process step after silver-plating the copper bonding surfaces 60, a coating of antioxidant 32 may be applied thereon. In either case, the antioxidant layer 32, as illustrated in FIG. 5, is typically about 1 microinch or less in thickness.

It may also be desired to attach a second layer of silver 28 atop each second metallic bonding surface 62, such as when the leadframe elements 82 are made of copper rather than aluminum. With this layer of silver 28 atop the second surface 62, the second end 22 of the bond wire 18 may be attached to the silver layer 28, as shown in FIG. 5. As with the first layer 24, the second layer 28 is preferably generally 2 to 10 microinches thick, and may have an organic antioxidant mixed therein or applied thereon.

In a preferred embodiment, the first copper bonding surface 60 is a copper mounting pad 12, while the second metallic bonding surface 62 is a copper leadframe 80. In this embodiment, the copper pads 12 are preferably immersion plated with silver (e.g., by using photoresist and pattern plating the PCB/substrate on which the pads 12 are carried), and the copper leadframe is also immersion plated. The resulting 2- to 10-microinch silver layers 24/28 provide the pads 12 and the leadframe 80 with both an oxidation barrier and a surface which may be wirebonded to easily without the formation of undesirable intermetallics. The use of an immersion silver-plated copper leadframe also provides the advantage that this construction is less expensive than the conventional construction which uses aluminum-copper-aluminum clad laminate material from which leadframes typically are stamped. Optionally, a 1- microinch or less coating of antioxidant 32 may be applied over each silver layer 24/28 by either dip coating, spraying, or otherwise depositing it thereon after plating, or by including the antioxidant within the ionic silver solution during plating.

A method for making the construction shown in FIGS. 4-5 is as follows. First, a dielectric substrate 10 an electronic component 14 , an electrical connector leadframe 80, and a wirebonding wire 18 having first and second ends 20/22 are provided. As mentioned above, a first copper bonding surface 60 and a second metallic bonding surface 62 must be provided on the substrate, component, or leadframe. Second, a 2- to 10-microinch first layer of silver 24 is deposited atop the first bonding surface 60, thereby producing a first silvered bonding surface 26. Third, the electronic component 14 or leadframe 80 is attached to the substrate 10 (e.g., by an adhesive or solder) such that the second bonding surface 62 is registered generally adjacent the first silvered bonding surface 26. Fourth, the first end 20 of the wire 18 is wirebonded to the first silvered surface 26 and the second end 22 of the wire 18 is wirebonded to the second surface 62.

The step of depositing the first layer of silver 24 may comprise plating the substrate, component, or leadframe in an ionic silver solution using immersion, electroless, or electrolytic plating. The step of wirebonding may be accomplished by thermocompression, thermosonic, or ultrasonic bonding.

The first layer of silver 24 may include an organic antioxidant mixed therein. Alternatively, the method may include a step of placing an organic antioxidant coating atop the first layer of silver between the second (depositing) and third (attaching) steps. The method may further include (between the first/providing step and the third/attaching steps) the step of depositing a second layer of silver 28 atop the second metallic bonding surface 62, thereby producing a second silvered bonding surface 29, wherein the second end 22 of the wire 18 is wirebonded to the second silvered surface 29.

Tests were conducted in which the present invention was compared to the commonly used HASL approach. In the tests, aluminum bonding wires 18 were ultrasonically bonded to 3-microinch silver layers atop copper mounting pads on an FR-4 substrate. Tests revealed that the bonds formed using the present invention were as strong as or stronger than bonds formed using the HASL approach, and under thermal cycling conditions (-25°C to +140°C) lasted for as long as or longer than the prior art bonds.

It should be apparent from the foregoing disclosure that the present invention may be used in a wide variety of applications. For example, the first and/or second bonding surfaces 60/62 may variously be substrate mounting pads 12, electronic component bond pads 16 or terminations/leads, or mounting sites 70 on leadframes, terminal lugs, or other electrical connectors, as illustrated in FIG. 6. At least one of the surfaces 60/62 is copper with a layer of silver 64 attached thereon; of course, both surfaces 60/62 may be copper with a silver layer 64 thereon as well. (That is, the second metallic surface 62 may be copper as well.) The only other requirement is that the two bonding surfaces 60/62 be disposed proximate to one another (e.g., typically less than 1 inch apart, and preferably less than 0.5 inch) and that they both be fixed with respect to each other and with respect to the substrate 10 to which they are directly or indirectly attached. (That is, the surfaces 60/62 may each be affixed directly to the substrate 10 itself, or disposed on an electronic component 14 or structure which is itself directly affixed to the substrate.)

Various other modifications to the present invention will, no doubt, occur to those skilled in the art to which the present invention pertains. For example, other metals besides silver may be used to coat the copper mounting pads, such as gold, palladium, and nickel; however, silver is believed to be an optimum coating for wirebonding as far as cost, ease of processing, etc., especially when using an immersion plating process. Also, it should be apparent that the present invention may be used in both heavy and fine wirebonding. Additionally, the electronic component 14 or connector leadframe 80 may first be attached to the substrate 10 and then selectively plated with silver, rather than the plating occurring before the attaching step.
Furthermore, it should be apparent that the silver plating of the first and second bonding surfaces 60/62 may be done in a single step, as may the antioxidant coating of the silvered surfaces 26/29. Moreover, it should be understood that the adjectives "first" and "second" (as applied to the nouns/phrases "end", "bonding surface", "layer of silver", etc.) do not necessarily refer to the order in which such elements are wirebonded. Also, although the foregoing disclosure refers repeatedly to only single bonding surfaces 60/62 at a time, it is more often the case that multiple bonding surfaces are involved, such as when multiple copper mounting pads 12 on a substrate comprise multiple first copper bonding surfaces 60. Other modifications not specifically mentioned here are also possible and within the scope of the present invention. It is the following claims, including all equivalents, which define the scope of the present invention.

## Claims

1. An electronic circuit assembly, comprising:
a dielectric substrate (10) having an electronic component (14) or an electrical connector leadframe (80) attached thereon;
a first copper bonding surface (60) on said substrate (10), said component (14), or said leadframe (80);
a second metallic bonding surface (62) on said substrate (10), said component (14), or said leadframe (80), wherein said second metallic bonding surface (62) is disposed proximate said first copper bonding surface (60);
a first layer of silver (24) attached atop said first copper bonding surface (60); and
a wirebonding wire (18) having a first end (20) and a second end (22), wherein said first end (20) is attached to said first layer of silver (24) atop said first copper bonding surface (60), and wherein said second end (22) is attached to said second metallic bonding surface (62).

2. An electronic circuit assembly according to claim 1, wherein said first layer of silver (24) is generally between 2 and 10 microinches thick.

3. An electronic circuit assembly according to either claim 1 or claim 2, wherein said wirebonding wire (18) is generally between 10 and 20 mils in diameter and is made of aluminum.

4. An electronic circuit assembly according to any one of the preceding claims, further including an organic antioxidant coating (32) atop said first layer of silver (24).

5. An electronic circuit assembly according to claim 4, wherein said organic antioxidant coating (32) includes benzimidazole, imidazole, or benzotriozole.

6. An electronic circuit assembly according to either claim 4 or claim 5, wherein said organic antioxidant coating is generally ≤ 1 microinch thick.

7. An electronic circuit assembly according to any one of the preceding claims, wherein said second metallic bonding surface (62) is copper and has a second layer (28) of silver attached thereon, wherein said second end (22) of said wirebonding wire (18) is attached to said second layer (28) of silver atop said second metallic bonding surface (62).

8. An electronic circuit assembly according to claim 7, wherein said first (24) and second (28) layers of silver are each generally between 2 and 10 microinches thick.

9. An electronic circuit assembly according to claim 7, further comprising an organic antioxidant coating (32) atop each of said first (24) and second (28) layers of silver.

10. An electronic circuit assembly according to claim 9, wherein each organic antioxidant coating (32) is generally ≤ 1 microinch thick and includes benzimidazole, imidazole, or benzotriozole.

11. An electronic circuit assembly according to any one of the preceding claims, wherein said first copper bonding surface (60) is a mounting pad on said substrate or a lead element of said electrical connector leadframe.

12. An electronic circuit assembly as claimed in claim 1 comprising:
a dielectric substrate (10) having a copper mounting pad (60) thereon, wherein said mounting pad (60) has a generally 2- to 10-microinch first layer (24) of silver attached thereon;
an electrical connector leadframe (80) having a metallic bonding surface thereon and being attached to said substrate (10) such that said metallic bonding surface is disposed within 1 inch of said copper bonding pad (60); and
an aluminium wirebonding wire (18) having a first end (20) and a second end (22), wherein said first end (20) is attached to said first layer (24) of silver atop said copper mounting pad (60), and wherein said second end (22) is attached to said metallic bonding surface on said leadframe (80).
